# DEMANDE DE BREVET EUROPEEN

(11) **EP 4 708 693 A1**
(43) Date de publication de la demande: **11.03.2026**
(21) Numéro de dépôt: 25198302.9
(22) Date de dépôt: 27.08.2025
(51) Int. Cl.: H03K 17/082

(54) **INTERRUPTEUR DE PROTECTION**

(30) Priorité: 09.09.2024 FR 2409526
(71) Demandeur: STMicroelectronics International N.V., 1228 Plan-les-Ouates, Geneva (CH)
(72) Inventeur: GRANGE, Karl, 37100 TOURS (FR)
(74) Mandataire: Cabinet Beaumont

(57) **Abrégé**

La présente description concerne un interrupteur (210) de protection contre les surtensions et les surintensités comprenant :
- un premier transistor (T211) de type NMOS adapté à recevoir entre ses bornes de conduction une première tension ;
- un deuxième transistor (T212) de type NMOS comprenant une borne de source reliée à une borne de source dudit premier transistor (T211), et étant adapté à recevoir entre ses bornes de conduction une deuxième tension inférieure à la première tension ; et
- un troisième transistor (T213) de type NMOS comprenant une borne de source reliée à une borne de source dudit premier transistor (T211), et étant adapté à recevoir entre ses bornes de conduction ladite deuxième tension.

## Description

### Domaine technique

La présente description concerne de façon générale les systèmes et dispositifs électroniques, et la protection des systèmes et dispositifs électroniques contre des phénomènes parasites tels que l'apparition de surtensions ou de surintensités.

### Technique antérieure

L'apparition d'une surtension ou d'une surintensité au sein d'un système ou dispositif électronique peut empêcher son bon fonctionnement et peut même l'endommager.

Il serait souhaitable de pouvoir améliorer, au moins en partie, certains aspects des dispositifs de protection contre les surtensions et les surintensités connus.

### Résumé de l'invention

Il existe un besoin pour des dispositifs de protection contre les surtensions et les surintensités plus performants.

Il existe un besoin pour des interrupteurs de protection contre les surtensions et les surintensités plus performants.

Il existe un besoin pour des interrupteurs de protection contre les surtensions et les surintensités présentant une meilleure compatibilité avec le dispositif à protéger.

Il existe un besoin pour des interrupteurs de protection contre les surtensions et les surintensités capables de détecter des surintensités de façon plus précise.

Il existe un besoin pour des interrupteurs de protection contre les surtensions et les surintensités de dimensions plus faibles.

Un mode de réalisation pallie tout ou partie des inconvénients des interrupteurs de protection contre les surtensions et les surintensités connus.

Un mode de réalisation pallie tout ou partie des inconvénients des dispositifs de protection contre les surtensions et les surintensités connus.

Un mode de réalisation prévoit un interrupteur de protection contre les surtensions et les surintensités comprenant :
- un premier transistor de type NMOS adapté à recevoir entre ses bornes de conduction une première tension ;
- un deuxième transistor de type NMOS comprenant une borne de source reliée à une borne de source dudit premier transistor, et étant adapté à recevoir entre ses bornes de conduction une deuxième tension inférieure à la première tension ; et
- un troisième transistor de type NMOS comprenant une borne de source reliée à une borne de source dudit premier transistor, et étant adapté à recevoir entre ses bornes de conduction ladite deuxième tension.

Selon un mode de réalisation, lesdits deuxième et troisième transistors fonctionnent en régime ohmique inverse.

Selon un mode de réalisation, la première tension est comprise entre 5 et 65 V.

Selon un mode de réalisation, la deuxième tension est comprise entre 5 et 8 V.

Selon un mode de réalisation, l'interrupteur comprend, en outre :
- un quatrième transistor de type NMOS adapté à recevoir entre ses bornes de conduction ladite première tension ;
- un cinquième transistor de type NMOS comprenant une borne de source reliée à une borne de source dudit quatrième transistor, et étant adapté à recevoir entre ses bornes de conduction ladite deuxième tension ; et
- un sixième transistor de type NMOS comprenant une borne de source reliée à une borne de source dudit quatrième transistor, et étant adapté à recevoir entre ses bornes de conduction ladite deuxième tension.

Selon un mode de réalisation, l'interrupteur comprend, en outre, un source de tension commandable et un circuit de gestion de ladite source de tension commandable, ladite source de tension commandable étant adaptée à fournir une tension entre ladite borne de source dudit deuxième transistor et ladite borne de grille dudit deuxième transistor, et entre ladite borne de source dudit troisième transistor et ladite borne de grille dudit troisième transistor.

Un autre mode de réalisation prévoit un dispositif de protection contre les surtensions et les surintensités comprenant un interrupteur décrit précédemment.

Selon un mode de réalisation, le dispositif comprend, en outre, un circuit de commande dudit interrupteur.

Selon un mode de réalisation, le dispositif comprend, en outre, un circuit de détection de surintensités reliée à une borne de drain dudit troisième transistor.

Selon un mode de réalisation, ledit circuit de détection de surintensités comprend un circuit de compensation d'une tension interne.

Selon un mode de réalisation, le dispositif comprend, en outre, un circuit de détection de surtensions reliée à une borne de drain dudit premier transistor.

Un autre mode de réalisation prévoit un dispositif électronique comprenant un dispositif de protection contre les surtensions et les surintensités décrit précédemment.

Un autre mode de réalisation prévoit un dispositif de recharge en énergie comprenant un dispositif de protection contre les surtensions et les surintensités décrit précédemment.

Un autre mode de réalisation prévoit un système électronique comprenant un dispositif électronique, un dispositif de recharge en énergie, et un dispositif de protection contre les surtensions et les surintensités décrit précédemment.

Un autre mode de réalisation prévoit un procédé de protection contre les surtensions et les surintensités utilisant un interrupteur décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un système électronique ;
la figure 2 représente un mode de réalisation d'un dispositif de protection contre les surtensions et les surintensités ;
la figure 3 représente un courbe illustrant le fonctionnement d'un transistor MOS ;
la figure 4 représente un autre mode de réalisation d'un dispositif de protection contre les surtensions et les surintensités ; et
la figure 5 représente un autre mode de réalisation d'un dispositif de protection contre les surintensités.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

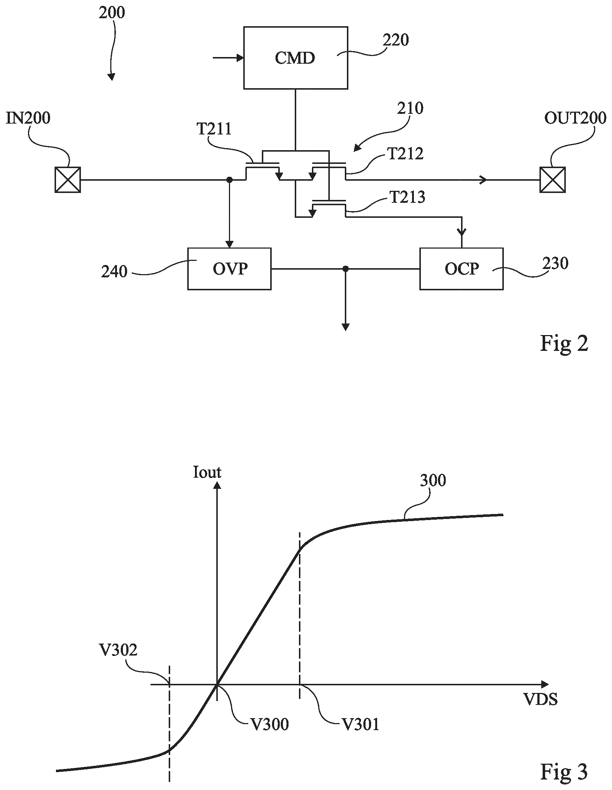

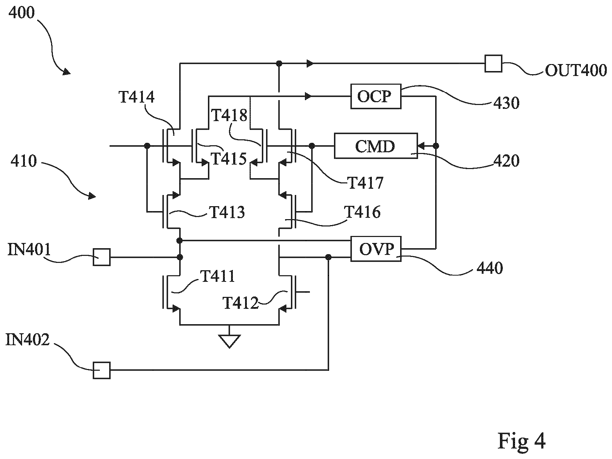

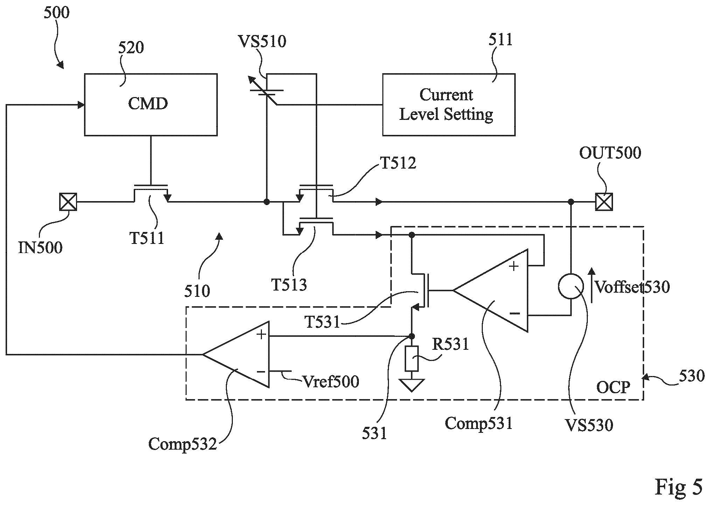

Les modes de réalisation décrits ci-après concernent la protection de dispositifs électroniques contre les surtensions et les surintensités, et concernent plus particulièrement un interrupteur de protection contre de tels phénomènes. Cet interrupteur comprend un premier transistor haute tension adapté à recevoir des surtensions, et des deuxièmes transistors basse tensions adaptés à détecter des surintensités. La structure de cet interrupteur est décrite en détail en relation avec les figures 2 et 3 et permet de s'affranchir de l'utilisation d'un transistor haute tension adapté à détecter des surintensités. Des variantes de cette structure sont décrites en relation avec les figures 4 et 5.

De plus, les modes de réalisation décrits ci-dessous sont particulièrement adaptés pour être utilisés dans tout type de marchés industriels où une protection contre les surtensions et les surintensités est nécessaire. Plus particulièrement, un tel interrupteur de protection peut être destiné à :
- l'industrie automobile, par exemple dans le domaine de l'électrification automobile ou dans le domaine des systèmes avancés d'aide à la conduite (Advanced Driver Assistance Systems - ADAS) ;
- l'industrie industrielle, par exemple dans le domaine de l'énergie verte, dans le domaine de l'électrification des infrastructures, de l'internet des objets (Internet of Things
- IoT) et des maisons intelligentes (SmartHome), où la consommation d'électricité et d'énergie et l'échange de données sont des éléments clés ;
- l'industrie de l'électronique personnelle, par exemple dans le domaine de la téléphonie mobile et de l'internet des objets (Internet of Things - IoT), ainsi que dans le domaine des interfaces haut débit ; et
- l'industrie des équipements de communication, des ordinateurs et des périphériques, par exemple dans le domaine des infrastructures et des centres de données (Data Centers), et dans le domaine des satellites en orbite terrestre basse (Low Earth Orbit - LEO).

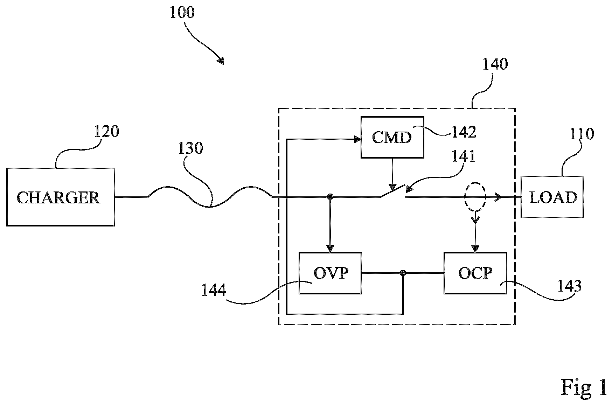

La figure 1 représente, très schématiquement et sous forme de blocs, un mode de réalisation d'un système électronique 100.

Le système électronique 100 comprend un dispositif électronique 110 (LOAD) comprenant un moyen de distribution d'énergie, comme une batterie, qui peut avoir besoin d'être rechargée. Pour cela, le système 100 comprend, en outre, un dispositif de recharge en énergie 120 (CHARGER) adapté à recharger le moyen de distribution d'énergie du dispositif électronique 110. Le dispositif 110 peut aussi être appelé dispositif à protéger.

Le système 100 comprend, en outre, un moyen de connexion électrique 130 des dispositifs 110 et 120. Selon un mode de réalisation, le moyen 130 est adapté à transmettre de l'énergie, et, le cas échant, des données, depuis le dispositif 120 jusqu'au dispositif 110. Selon un exemple, le moyen 130 est un câble. Le moyen 130 peut supporter tout type de protocole de transmission d'énergie et, le cas échéant, de transmission de données. Selon un exemple, le moyen 130 peut aussi être utilisé comme moyen de transmission d'énergie, et, le cas échéant, de données, allant du dispositif 110 vers le dispositif 120.

Selon un mode de réalisation, le système 100 comprend, en outre, un dispositif de protection contre les surtensions et les surintensités 140 permettant de protéger le dispositif 110 contre les surtensions et les surintensités. Plusieurs modes de réalisation de dispositifs de protection contre les surtensions sont décrits en relation avec les figures 2 à 5.

En figure 1, le dispositif de protection 140 est représenté comme étant disposé entre le moyen 130 et le dispositif 110, mais à titre de variante, le dispositif 140 peut faire partie, c'est-à-dire être intégré, du dispositif 110, du dispositif de recharge 120 ou du moyen 130.

Selon un mode de réalisation, le dispositif de protection 140 comprend :
- un interrupteur de protection 141 ;
- un circuit de commande 142 (CMD) de l'interrupteur 141 ;
- un circuit de détection des surintensités 143 (OCP) ; et
- un circuit de détection des surtensions 144 (OVP).

Selon un mode de réalisation, l'interrupteur 141 est disposé de façon à arrêter l'alimentation du dispositif 110 par le dispositif 120 en cas de détection d'une surtension et/ou d'une surintensité. Autrement dit, l'interrupteur 141 est disposé de façon à déconnecter le dispositif 110 du dispositif 120 en cas de détection d'une surtension et/ou d'une surintensité. On appelle par la suite l'entrée de l'interrupteur 141, la borne de l'interrupteur 141 reliée au dispositif 120, et la sortie de l'interrupteur 141 la borne de l'interrupteur 141 reliée au dispositif 110. Des exemples détaillés de l'interrupteur 141 sont décrits en relation avec les figures 2, 4 et 5.

Selon un mode de réalisation, le circuit de commande 142 est adapté à recevoir une information de la part des circuits de détection 143 et 144 et d'appliquer une commande à l'interrupteur 141 en fonction de cette information. Plus particulièrement, si le circuit de commande reçoit de la part des circuits de détection 143 et 144 une information indiquant qu'une surtension ou une surintensité est détectée, alors le circuit de commande 142 envoie une commande d'ouverture à l'interrupteur 141 qui devient alors non conducteur.

Selon un mode de réalisation, le circuit de détection des surintensités 143 est relié, de préférence connecté, à la sortie de l'interrupteur 141, c'est-à-dire entre l'interrupteur 141 et le dispositif 110. Un exemple détaillé du circuit 143 est décrit en relation avec la figure 5.

Selon un mode de réalisation, le circuit de détection des surtensions 144 est relié, de préférence connecté, à l'entrée de l'interrupteur 141, c'est-à-dire entre l'interrupteur 141 et le dispositif 120.

Un mode de mise en oeuvre d'un procédé de protection contre les surtensions et les surintensités est le suivant. Lorsqu'une surintensité est détectée par le dispositif de détection 143, une information est envoyée au circuit de commande 142 qui transmet alors une commande d'ouverture de l'interrupteur 141 qui déconnecte alors le dispositif 110 du dispositif 120. Lorsqu'une surtension est détectée par le dispositif de détection 144, une information est envoyée au circuit de commande 142 qui transmet alors une commande d'ouverture de l'interrupteur 141 qui déconnecte alors le dispositif 110 du dispositif 120. Lorsqu'aucune surintensité et qu'aucune surtension n'est détectée, l'interrupteur 141 est conducteur.

La figure 2 représente, schématiquement et partiellement sous forme de blocs, un mode de réalisation d'un dispositif de protection contre les surtensions et les surintensités 200.

Le dispositif de protection 200 est similaire au dispositif de protection 140 décrit en relation avec la figure 1. Les éléments communs aux dispositifs 140 et 200 ne sont pas décrits de nouveau en détail. Seules les différences entre les dispositifs 140 et 200 sont mises en exergue.

Ainsi, comme le dispositif 140, le dispositif 200 comprend :
- un interrupteur de protection 210 du type de l'interrupteur de protection 141 ;
- un circuit de commande 220 (CMD) de l'interrupteur 210 du type du circuit de commande 142 ;
- un circuit de détection des surintensités 230 (OCP) du type du circuit de détection des surintensités 143 ; et
- un circuit de détection des surtensions 240 (OVP) du type du circuit de détection des surtensions 144.

Selon un exemple, le dispositif 200 comprend une borne d'entrée IN200 adaptée à être reliée à un dispositif du type du dispositif 120 décrit en relation avec la figure 1. Selon un exemple, le dispositif 200 comprend, en outre, une borne de sortie OUT200 adaptée à être reliée à un dispositif du type du dispositif 110 décrit en relation avec la figure 1.

Selon un mode de réalisation, l'interrupteur 210 comprend un premier transistor T211. Selon un exemple, le transistor T211 est un transistor à effet de champ à grille métal-oxyde (metal-oxide-semiconductor field-effect transistor), ou transistor MOSFET, ou transistor MOS. De plus, le transistor T211 est un transistor MOS à canal N, ou transistor MOS de type N, ou transistor NMOS. Par ailleurs, le transistor T211 est adapté à recevoir des hautes tensions entre ses bornes de conduction, c'est-à-dire ses bornes de source et de drain. Plus particulièrement, le transistor T211 est adapté à recevoir, entre ses bornes de conduction, une tension maximale comprise entre 5 et 65 V, par exemple supérieur à 10 ou 12 V, par exemple de l'ordre de 18 V.

Selon un mode de réalisation, l'interrupteur 210 comprend, en outre, deux transistors T212 et T213. Selon un exemple, les transistors T211 et T212 sont des transistors NMOS. Par ailleurs, les transistors T212 et T213 sont adaptés à recevoir des basses tensions entre leurs bornes de conduction. Autrement dit, les transistors T212 et T213 sont adaptés à recevoir, entre leurs bornes de conduction, une tension maximale inférieure à la tension maximale qu'est capable de supporter le transistor T211. Plus particulièrement, les transistors T212 et T213 sont adaptés à recevoir, entre leurs bornes de conduction, une tension comprise entre 5 et 8 V, par exemple de l'ordre de 5 V.

Selon un mode de réalisation, une borne de drain du transistor T211 est reliée, de préférence connectée, à la borne d'entrée IN200 du dispositif 200, et une borne de source du transistor T211 est reliée, de préférence connectée, aux bornes de source des transistors T212 et T213. Selon un mode de réalisation, une borne de drain du transistor T212 est reliée, de préférence connectée, à la borne de sortie OUT200 du dispositif 200. Selon un mode de réalisation, une borne de drain du transistor T213 est reliée, de préférence connectée, à une entrée du circuit de détection de surintensités 230. Selon un mode de réalisation, les bornes de grilles des transistors T211, T212 et T213 sont toutes reliées, de préférence connectées, à une sortie du circuit de commande 220.

Le transistor T211 est utilisé comme un interrupteur de puissance permettant de déconnecter le dispositif à protéger du dispositif de recharge lors de la détection d'une surtension ou d'une surintensité. Le transistor T212 est utilisé comme un transistor de conduction permettant de conduire l'énergie jusqu'au dispositif à protéger. Le transistor T213 est utilisé comme un transistor de mesure de courant puisqu'il transmet une fraction du courant reçu par le dispositif à protéger au circuit de détection des surintensités 230. Selon un mode de réalisation, pour un bon fonctionnement de l'interrupteur 210, les transistors T212 et T213 fonctionnent en régime ohmique inverse. Ce régime est décrit en détail en relation avec la figure 3. Le circuit de commande 200 est donc adaptée à fournir aux transistors T212 et T213 une commande leur permettant de fonctionner en régime ohmique inverse.

Un avantage de l'interrupteur 210 est qu'il présente un encombrement moindre comparé aux interrupteurs de protection déjà existants. En effet, il est commun d'utiliser deux transistors haute tension pour former un transistor de protection contre les surtensions et les surintensités. Les transistors haute tension présentent généralement une grande surface par comparaison à des transistors basse puissance. L'utilisation d'un seul transistor haute tension et de deux transistors basse puissance permet de réduire l'encombrement de l'interrupteur 210.

La figure 3 représente une courbe 300 illustrant une caractéristique de fonctionnement d'un transistor de type NMOS. Plus particulièrement la courbe 300 illustre l'évolution du courant de sortie Iout fourni au niveau de la borne de source d'un transistor NMOS en fonction de l'évolution de la tension VDS entre ses bornes de conduction.

Lorsque la tension VDS est positive, et plus précisément compris entre une tension nulle V300 et une tension de saturation V301, le transistor fonctionne dans un régime ohmique. Autrement dit, dans ce cas, le transistor peut être assimilé à une résistance de résistivité positive.

Lorsque la tension VDS dépasse la tension de saturation I301, le transistor fonctionne dans un régime de saturation. Autrement dit, son courant de sortie Iout augmente de moins en moins vite jusqu'à atteindre un palier.

Lorsque la tension VDS est négative, et plus précisément comprise entre la tension nulle V300 et une tension de saturation inverse V302, le transistor fonctionne dans un régime ohmique inverse. Autrement dit, dans ce cas, le transistor peut toujours être assimilé à une résistance jusqu'à la tension de saturation inverse V302.

Lorsque la tension VDS dépasse la tension de saturation inverse V302, le transistor fonctionne dans un régime de saturation inverse. Autrement dit, le transistor fonctionne comme une diode.

La figure 4 représente, schématiquement et partiellement sous forme de blocs, un autre mode de réalisation d'un dispositif de protection contre les surtensions et les surintensités 400.

Le dispositif de protection 400 est similaire au dispositif de protection 140 décrit en relation avec la figure 1 et au dispositif 200 décrit en relation avec la figure 2. Les éléments communs aux dispositifs 140, 200 et 400 ne sont pas décrits de nouveaux en détail. Seules les différences entre les dispositifs 140, 200 et 400 sont mises en exergue.

Ainsi, comme le dispositif 200, le dispositif 400 comprend :
- un interrupteur de protection 410 du type de l'interrupteur de protection 210 ;
- un circuit de commande 420 (CMD) de l'interrupteur 410 du type du circuit de commande 220 ;
- un circuit de détection des surintensités 430 (OCP) du type du circuit de détection des surintensités 230 ; et
- un circuit de détection des surtensions 440 (OVP) du type du circuit de détection des surtensions 240.

Le dispositif 400 se différencie du dispositif 200 en ce qu'il comprend deux bornes d'entrée IN401 et IN402, et qu'il comprend donc un interrupteur de protection 410 double. Le dispositif 400 comprend une unique borne de sortie OUT400.

Selon un mode de réalisation, l'interrupteur de protection 410 comprend deux transistors NMOS T411 et T412 adaptés à recevoir des hautes tensions, c'est-à-dire du type du transistor T211. Une borne de source du transistor T411 est reliée, de préférence connectée, à une borne de source du transistor T412 et à un noeud recevant un potentiel de référence, par exemple la masse. Une borne de drain du transistor T411 est reliée, de préférence connectée, à la borne d'entrée IN401 et à une entrée du circuit de détection de surtensions 440. Une borne de drain du transistor T412 est reliée, de préférence connectée, à la borne d'entrée IN402 et à une autre entrée du circuit de détection de surtensions 440. Les bornes de grille des transistors T411 et T412 sont reliées, de préférence connectées, à des sorties (non représentée en figure 4) du circuit de commande 420.

Selon un mode de réalisation, l'interrupteur de protection 410 comprend, en outre, trois transistors NMOS T413, T414 et T415 formant une structure du type de la structure de l'interrupteur 210 décrit en relation avec la figure 2. Plus particulièrement, le transistor T413 est adapté à recevoir des hautes tensions, c'est-à-dire est du type du transistor T211, et les transistors T414 et T415 sont adaptés à recevoir des basses tensions, c'est-à-dire sont du type des transistors T212 et T213.

Selon un mode de réalisation, une borne de drain du transistor T413 est reliée, de préférence connectée, à la borne d'entrée IN401 du dispositif 400, et une borne de source du transistor T413 est reliée, de préférence connectée, aux bornes de source des transistors T414 et T415. Selon un mode de réalisation, une borne de drain du transistor T414 est reliée, de préférence connectée, à la borne de sortie OUT400 du dispositif 400. Selon un mode de réalisation, une borne de drain du transistor T415 est reliée, de préférence connectée, à une entrée du circuit de détection de surintensités 430. Selon un mode de réalisation, les bornes de grilles des transistors T413, T414 et T415 sont toutes reliées, de préférence connectées, à une sortie du circuit de commande 420.

Selon un mode de réalisation, l'interrupteur de protection 410 comprend, en outre, trois autres transistors NMOS T416, T417 et T418 formant une structure du type de la structure de l'interrupteur 210 décrit en relation avec la figure 2. Plus particulièrement, le transistor T416 est adapté à recevoir des hautes tensions, c'est-à-dire est du type du transistor T211, et les transistors T417 et T418 sont adaptés à recevoir des basses tensions, c'est-à-dire sont du type des transistors T212 et T213.

Selon un mode de réalisation, une borne de drain du transistor T416 est reliée, de préférence connectée, à la borne d'entrée IN402 du dispositif 400, et une borne de source du transistor T416 est reliée, de préférence connectée, aux bornes de source des transistors T417 et T418. Selon un mode de réalisation, une borne de drain du transistor T417 est reliée, de préférence connectée, à la borne de sortie OUT400 du dispositif 400. Selon un mode de réalisation, une borne de drain du transistor T418 est reliée, de préférence connectée, à une entrée du circuit de détection de surintensités 430. Selon un mode de réalisation, les bornes de grilles des transistors T416, T417 et T418 sont toutes reliées, de préférence connectées, à une sortie du circuit de commande 420.

Comme décrit en relation avec les figures 2 et 3, les transistors T414, T415, T417 et T418 sont tous commandés pour fonctionner en régime ohmique inverse.

Un avantage de ce dispositif est qu'il permet de détecter des surtensions et des surintensités sur deux bornes d'entrée.

Par ailleurs, il est à la portée de la personne du métier de généraliser le mode de réalisation décrit en relation avec la figure 4 à un dispositif de protection contre les surtensions et les surintensités comprenant plus de deux entrées.

La figure 5 représente, schématiquement et partiellement sous forme de blocs, un autre mode de réalisation d'un dispositif de protection contre les surtensions et les surintensités 500.

Le dispositif de protection 500 est similaire au dispositif de protection 140 décrit en relation avec la figure 1 et au dispositif 200 décrit en relation avec la figure 2. Les éléments communs aux dispositifs 140, 200 et 500 ne sont pas décrits de nouveaux en détail. Seules les différences entre les dispositifs 140, 200 et 500 sont mises en exergue.

Ainsi, comme le dispositif 200, le dispositif 500 comprend :
- un interrupteur de protection 510 du type de l'interrupteur de protection 210 ;
- un circuit de commande 520 (CMD) de l'interrupteur 510 du type du circuit de commande 220 ;
- un circuit de détection des surintensités 530 (OCP) du type du circuit de détection des surintensités 230 ; et
- selon un exemple, un circuit de détection des surtensions du type du circuit de détection des surtensions 240 (non représenté en figure 5).

Le dispositif 500 se différencie du dispositif 200 en ce que l'interrupteur 510 est adapté à filtrer les surintensités survenant au niveau des bornes d'entrée.

Selon un mode de réalisation, l'interrupteur de protection 510 comprend, en outre, trois transistors NMOS T511, T512 et T513 formant une structure du type de la structure de l'interrupteur 210 décrit en relation avec la figure 2. Plus particulièrement, le transistor T511 est adapté à recevoir des hautes tensions, c'est-à-dire est du type du transistor T211, et les transistors T512 et T513 sont adaptés à recevoir des basses tensions, c'est-à-dire sont du type des transistors T212 et T213.

Selon un mode de réalisation, une borne de drain du transistor T511 est reliée, de préférence connectée, à une borne d'entrée IN501 du dispositif 500, et une borne de source du transistor T511 est reliée, de préférence connectée, aux bornes de source des transistors T512 et T513. Selon un mode de réalisation, une borne de drain du transistor T512 est reliée, de préférence connectée, à une borne de sortie OUT500 du dispositif 500. Selon un mode de réalisation, une borne de drain du transistor T513 est reliée, de préférence connectée, à une entrée du circuit de détection de surintensités 530. Selon un mode de réalisation, la borne de grille du transistor T511 est reliée, de préférence connectée, à une sortie du circuit de commande 520.

Selon un mode de réalisation, l'interrupteur 510 comprend, en outre, une source de tension commandable VS510 et un circuit de gestion 511 (Current Level Setting) de source de tension commandable VS510. La source de tension est adaptée à fournir un potentiel de commande aux transistors T512 et T513 et à adapter ce potentiel de commande en fonction de la valeur du courant transmis entre les bornes IN500 et OUT500.

De plus, selon un exemple, le circuit de détection des surintensités peut comprendre :
- un transistor NMOS T531 ;
- deux comparateurs Comp531 et Comp532 ;
- une résistance R531 ; et
- un circuit de compensation d'une tension interne (VS530) du comparateur.

Selon un exemple, une borne de drain du transistor T531 est reliée, de préférence connectée, à la borne de drain du transistor T513, et une borne de source du transistor T531 est reliée, de préférence connectée, à un noeud N531. Une borne de grille du transistor T531 est reliée, de préférence connectée, à une sortie du comparateur Comp531. Une première borne de la résistance R531 est reliée, de préférence connectée, au noeud N531, et une deuxième borne de la résistance R531 est reliée, de préférence connectée, à un noeud fournissant un potentiel de référence, par exemple la masse. Une borne non inverseuse (+) du comparateur est reliée, de préférence connectée, au noeud N531, et une borne inverseuse (-) est reliée à la borne de sortie OUT500 du dispositif 500 par l'intermédiaire du circuit VS530. Selon un exemple, le circuit VS530 est une source de tension fournissant une tension Voffset230 compensant une tension de décalage interne du comparateur Comp530. Le comparateur Comp531 et le transistor forment un étage de conversion du courant fourni par le transistor T513 en une tension.

Selon un exemple, le comparateur Comp532 est utilisé pour comparer la tension fournie par l'étage de conversion avec une tension de référence Vref500. C'est un étage de détection d'une surintensité. Pour cela, une borne non inverseuse (+) du comparateur Comp532 est reliée, de préférence connectée, à la borne de source du transistor T531. Une borne inverseuse (-) du comparateur Comp532est adaptée à recevoir la tension de référence Vref500. Une sortie du comparateur Comp532 est reliée, de préférence connectée, au circuit de commande 520.

Un mode de mise en oeuvre d'un procédé de protection contre les surtensions et les surintensités est le suivant. Lorsqu'une surintensité est détectée par le dispositif de détection 530, une information est envoyée au circuit 511 qui transmet alors une commande d'adaptation de l'ouverture des interrupteurs T512 et T513 qui déconnecte alors le dispositif à protéger du dispositif de recharge. Lorsqu'une surtension est détectée par le dispositif de détection de surtension (non représenté en figure 5), une information est envoyée au circuit de commande 520 qui transmet alors une commande d'ouverture de l'interrupteur T511 qui déconnecte alors le dispositif à protéger du dispositif de recharge.

Un avantage de ce mode de réalisation est qu'il permet de compenser la tension de décalage Voffset530 du comparateur Comp531. En effet, cette tension Voffset est constante mais le courant qu'elle fournit est dépendant de la résistance à l'état passant du transistor T513. Plus cette résistance est petite, plus le courant résultant de la tension Voffset est petit, il suffit donc de faire varier la résistance du transistor T513 pour faire varier l'erreur du circuit de détection de surintensité.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits en relation avec les figures 4 et 5 peuvent être combiné sans faire preuve d'un effort inventif conséquent.

Enfin, la mise en oeuvre pratique des modes de réalisation et variantes décrits est à la portée de la personne du métier à partir des indications fonctionnelles données ci-dessus.

## Revendications

1. Interrupteur (141 ; 210 ; 410 ; 510) de protection contre les surtensions et les surintensités comprenant :
- un premier transistor (T211 ; T413, T416 ; T511) de type NMOS adapté à recevoir entre ses bornes de conduction une première tension ;
- un deuxième transistor (T212 ; T414, T417 ; T512) de type NMOS comprenant une borne de source reliée à une borne de source dudit premier transistor (T211 ; T413, T416 ; T511), et étant adapté à recevoir entre ses bornes de conduction une deuxième tension inférieure à la première tension ; et
- un troisième transistor (T213 ; T415, T418 ; T513) de type NMOS comprenant une borne de source reliée à une borne de source dudit premier transistor (T211 ; T413, T416 ; T511), et étant adapté à recevoir entre ses bornes de conduction ladite deuxième tension.

2. Interrupteur selon la revendication 1, dans lequel lesdits deuxième et troisième transistors (T212, T213 ; T414, T415, T417, T418 ; T512, T513) fonctionnent en régime ohmique inverse.

3. Interrupteur selon la revendication 1 ou 2, dans lequel la première tension est comprise entre 5 et 65 V.

4. Interrupteur selon l'une quelconque des revendications 1 à 3, dans lequel la deuxième tension est comprise entre 5 et 8 V.

5. Interrupteur selon l'une quelconque des revendications 1 à 4, comprenant, en outre :
- un quatrième transistor (T416, T413) de type NMOS adapté à recevoir entre ses bornes de conduction ladite première tension ;
- un cinquième transistor (T417, T414) de type NMOS comprenant une borne de source reliée à une borne de source dudit quatrième transistor (T416, T413), et étant adapté à recevoir entre ses bornes de conduction ladite deuxième tension ; et
- un sixième transistor (T418, T415) de type NMOS comprenant une borne de source reliée à une borne de source dudit quatrième transistor (T416, T413), et étant adapté à recevoir entre ses bornes de conduction ladite deuxième tension.

6. Interrupteur selon l'une quelconque des revendications 1 à 5, comprenant, en outre, un source de tension commandable (VS510) et un circuit de gestion (511) de ladite source de tension commandable (VS510), ladite source de tension commandable (VS510) étant adaptée à fournir une tension entre ladite borne de source dudit deuxième transistor (T512) et ladite borne de grille dudit deuxième transistor (T512), et entre ladite borne de source dudit troisième transistor (T513) et ladite borne de grille dudit troisième transistor (T513).

7. Dispositif de protection contre les surtensions et les surintensités (140 ; 200 ; 400 ; 500) comprenant un interrupteur (141 ; 210 ; 410 ; 510) selon l'une quelconque des revendications 1 à 6.

8. Dispositif selon la revendication 7, comprenant, en outre, un circuit de commande (142 ; 220 ; 420 ; 520) dudit interrupteur (141 ; 210 ; 410 ; 510).

9. Dispositif selon la revendication 7 ou 8, comprenant, en outre, un circuit de détection de surintensités (143 ; 230 ; 430 ; 530) reliée à une borne de drain dudit troisième transistor (T213 ; T415, T418 ; T513).

10. Dispositif selon la revendication 9, dans lequel ledit circuit de détection de surintensités (530) comprend un circuit de compensation d'une tension interne (VS530).

11. Dispositif selon l'une quelconque des revendications 7 à 10, comprenant, en outre, un circuit de détection de surtensions (144 ; 240 ; 440) reliée à une borne de drain dudit premier transistor (T211 ; T413, T416 ; T511).

12. Dispositif électronique (110) comprenant un dispositif de protection contre les surtensions et les surintensités (140 ; 200 ; 400 ; 500) selon l'une quelconque des revendications 7 à 11.

13. Dispositif de recharge en énergie (120) comprenant un dispositif de protection contre les surtensions et les surintensités (140 ; 200 ; 400 ; 500) selon l'une quelconque des revendications 7 à 11.

14. Système électronique (100) comprenant un dispositif électronique (110), un dispositif de recharge en énergie (120), et un dispositif de protection contre les surtensions et les surintensités (140 ; 200 ; 400 ; 500) selon l'une quelconque des revendications 7 à 11.

15. Procédé de protection contre les surtensions et les surintensités utilisant un interrupteur (141 ; 210 ; 410 ; 510) selon l'une quelconque des revendications 1 à 6.
